# FASCICULE DE BREVET EUROPEEN

(11) **EP 1 391 920 B1**
(45) Date de publication et mention de la délivrance du brevet: **21.08.2013**
(21) Numéro de dépôt: 03102130.6
(22) Date de dépôt: 11.07.2003
(51) Int. Cl.: G03F 1/00, G03F 7/20, H01L 21/027, H01L 21/84

(54) **Procédé de fabrication d'une matrice active et masque correspondants**
Verfahren zur Herstellung einer aktiven Matrix und Maske für solche Herstellung
Method of fabricating an active matrix, and associated mask

(30) Priorité: 06.08.2002 FR 0209998
(43) Date de publication de la demande: 25.02.2004
(73) Titulaire: Thales, 92200 Neuilly Sur Seine (FR)
(72) Inventeur: Saluel, Didier, 38160 ST SAUVEUR (FR); Terrien, Jean-Charles, 38500 LA BUISSE (FR); Lebrun, Hugues, 38500 COUBLEVIE (FR)
(74) Mandataire: Esselin, Sophie

(56) Documents cités:
- JP-A- 2 144 535
- JP-A- 7 295 231
- JP-A- 2000 180 894
- US-A- 5 656 526
- US-A- 5 795 686
- US-A1- 2001 052 966
- ROMINGER J P: "Seamless stitching for large area integrated circuit manufacturing" PROCEEDINGS OF THE SPIE - THE INTERNATIONAL SOCIETY FOR OPTICAL ENGINEERING USA, vol. 922, 1988, pages 188-193, XP002479507 ISSN: 0277-786X

## Description

La présente invention se rapporte à un procédé de fabrication de matrices actives pour dispositifs de visualisation électro-optiques. Elle s'applique plus particulièrement à la fabrication d'écrans plats haute densité. Elle s'applique plus généralement à des afficheurs matriciels utilisés en vision directe ou en projection.

De façon simplifiée, un dispositif de visualisation à matrice active comprend des cellules disposées selon un réseau croisé de lignes et de colonnes, chaque cellule comprenant un élément pixel associé à un commutateur électronique formé par un élément actif, transistor ou diode, relié électriquement à une colonne du réseau et qui relie l'élément pixel à une ligne du réseau. Ces cellules sont toutes identiques. Elles sont obtenues à partir du même dessin à chaque niveau de fabrication. Ces cellules forment la zone active du circuit de matrice. Des circuits de contrôle et d'adressage des lignes et colonnes de la matrice sont disposés en périphérie. Ces circuits forment la zone périphérique de la matrice.

La zone active des matrices actives pour des écrans haute densité ayant une surface importante, bien supérieure à la dimension des champs d'insolation, leur fabrication nécessite l'utilisation d'un photo-répéteur (*stepper* dans la littérature anglo-saxonne) pour reporter et insoler plusieurs fois le même masque ou réticule, par lequel les motifs des cellules sont formés. Dans un exemple typique, pour la réalisation d'un écran de visualisation de 600 lignes par 600 lignes, on reporte neuf fois le même masque pour couvrir toute la surface de la zone active.

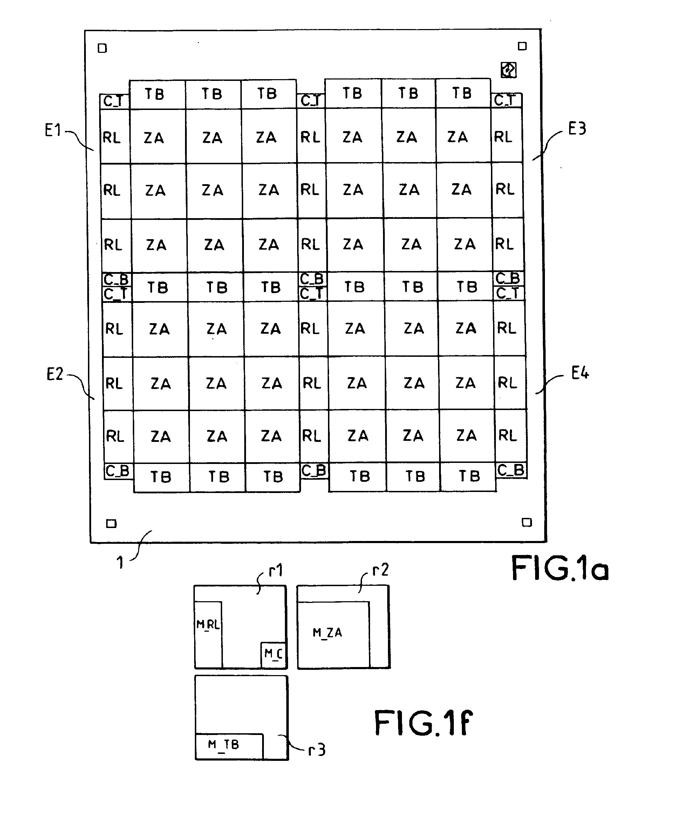

Sur la figure 1a, on a représenté une dalle de verre 1 sur laquelle on réalise quatre écrans de visualisation E1 à E4. Le masque de zone active est reporté neuf fois pour chaque écran, correspondant sur la dalle aux champs insolés marqués ZA, pour Zone Active. Dans cet exemple, la zone périphérique est obtenue au moyen de quatre masques de périphérie : les champs insolés correspondants sont marqués T-B pour "*Top-Bottom*", correspondant à la partie périphérique de contrôle des colonnes; RL pour "*Right-Left*", correspondant à la partie périphérique de contrôle des lignes de la matrice et C-T (pour *Coin-Top*) et C-B (pour *Coin-Bottom*) correspondants respectivement aux coins supérieurs et inférieurs dans la zone périphérique des écrans. Les écrans sont ensuite séparés.

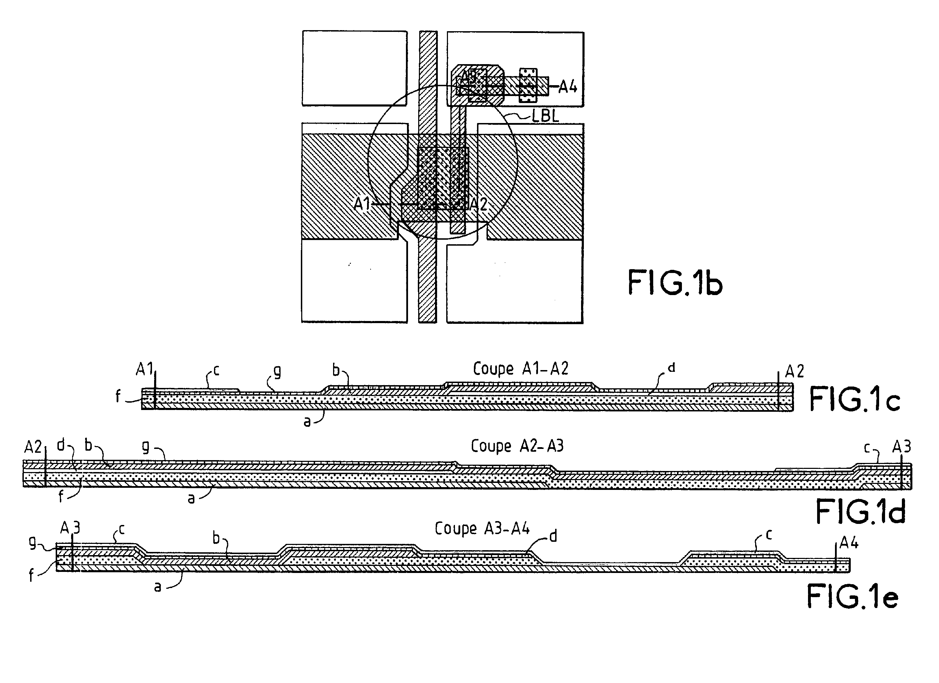

En pratique, on a un empilement de couches conductrices et de couches isolantes pour réaliser une cellule de matrice active. Pour chacun des niveaux de fabrication, on a un jeu de masques avec des dessins correspondant au niveau concerné. Si on prend l'exemple d'une cellule de matrice active à transistors à couches minces, ou transistors TFT, représentée en vue de dessus sur la figure 1b et en coupes longitudinales selon A1-A2, A2-A3 et A3-A4 sur les figures 1c à 1e, les couches conductrices comprennent différentes couches métalliques, par exemple une couche a de titane-molybdène (TiMo) pour les lignes de sélection et les grilles des transistors, une couche b de molybdène (Moly) pour les sources et drains des transistors et les colonnes de la matrice, une couche c transparente d'oxyde d'étain et d'indium (ITO) pour les électrodes pixel et une couche mince d de semi-conducteur (silicium amorphe intrinsèque, dopé n⁺, ...) pour le canal des transistors. Il y a aussi différentes couches d'isolant f, g (nitrure,....) sur lesquelles on vient notamment graver des contacts de périphérie. Pour chacune de ces couches, on a un dépôt d'une couche du matériau, suivi d'une couche de résine photosensible, puis photo-insolation au travers d'un masque ou réticule, révélation (développement) et gravure. A chacune de ces couches correspond donc un niveau de masquage, avec un jeu de masques correspondant. Dans l'exemple illustré sur la figure 1.b, on a ainsi six niveaux de masquage, auxquels se rajoute généralement un septième niveau, correspondant à une couche opaque isolante (organique) que l'on vient graver par dessus la couche d'isolant g, pour servir de masque optique " LBL" (*Light Blocking Layer)* au-dessus de chaque transistor (figure 1b). Ces masques sont formés sur un ou plusieurs réticules, en fonction de la place disponible sur ces réticules et des règles de dessin applicables. Pour le niveau de fabrication représenté sur la figure 1a, on utilise par exemple le jeu de masques [M-ZA, M-TB, M-RL, M-c] illustré sur la figure 1f, et qui est réalisé sur trois réticules r1, r2 et r3. Le masque de coin M-c regroupe les dessins pour le coin supérieur et le coin inférieur correspondant aux champs insolés C-T et C-B sur la figure 1a. Une particularité du masque de la zone active, est qu'il est formé d'un dessin de motifs identiques, répartis selon un réseau croisé de lignes et de colonnes, chaque motif correspondant à une cellule de la matrice.

Dans une étape d'insolation des dessins ou motifs de la zone active, le même masque M-ZA est ainsi reporté successivement plusieurs fois, neuf fois dans l'exemple illustré, de façon à couvrir toute la surface de la zone active. Ce report se fait bord à bord, le long des lignes et des colonnes. Il se fait avec une certaine imprécision correspondant à la tolérance de positionnement du photo-répéteur utilisé et aux défauts liés à la photo-insolation. Ce sont notamment les effets de bord, de grandissement, d'aberration optique, de rotation ou de désalignement en X et en Y du masque. Ces défauts sont variables d'un champ d'insolation à l'autre. Ils se traduisent par des imprécisions dans la reproduction de l'image ou du dessin au niveau de la frontière ou jonction entre deux champs d'insolation successifs. C'est le défaut dit de "*stepper pattern*" qui agit sur les qualités électro-optiques du dispositif de visualisation. Ce défaut correspond à l'impact visuel d'une variation des couplages capacitifs parasites des cellules de la matrice situées à la frontière entre deux champs d'insolation successifs. Par exemple, dans le cas d'une matrice active à transistors à couches minces ou transistors TFT, il y a des couplages parasites entre la grille (ligne), la source (colonne) et l'électrode pixel ou le drain. Ces couplages sont sensibles aux défauts des dessins des grilles, des couches semiconductrices, des colonnes et des drains des transistors TFT et des électrodes pixel. Le long de la frontière entre deux champs d'insolation, ces couplages peuvent avoir des valeurs qui s'écartent de la valeur moyenne des couplages à l'intérieur même des champs d'insolation.

Pour un écran sans défaut dit de " stepper pattern ", la valeur des couplages est uniforme sur toute la surface de l'écran. La variation des valeurs des couplages entre deux zones d'insolation due aux désalignements des dessins insolés sur la matrice agit sur la luminance des pixels concernés le long des frontières entre les différentes zones d'insolation. La tension réelle appliquée aux bornes des éléments pixels correspondants va donc être différente le long de ces frontières, ce qui va se voir visuellement : c'est le stepper pattern.

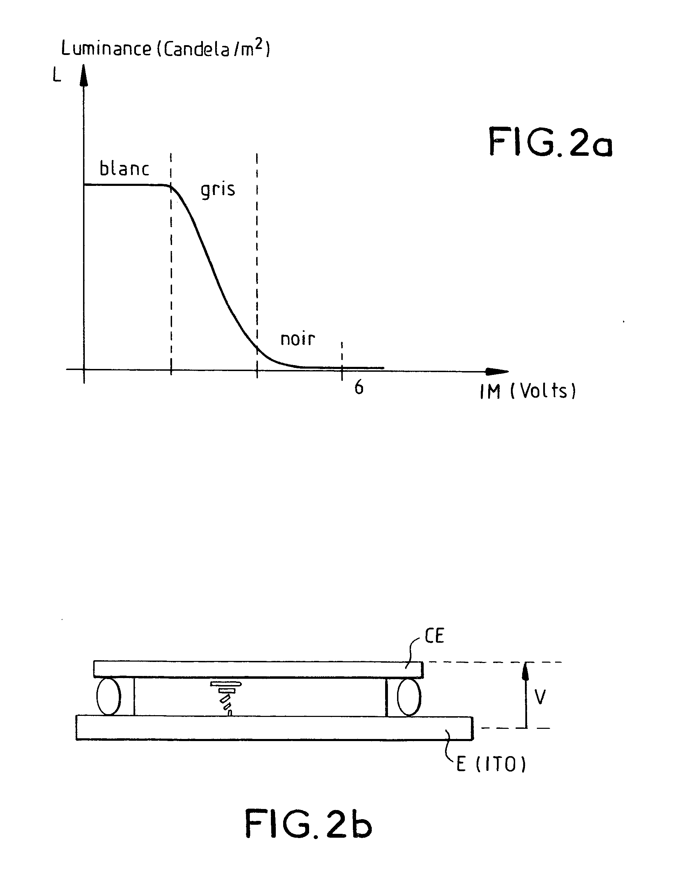

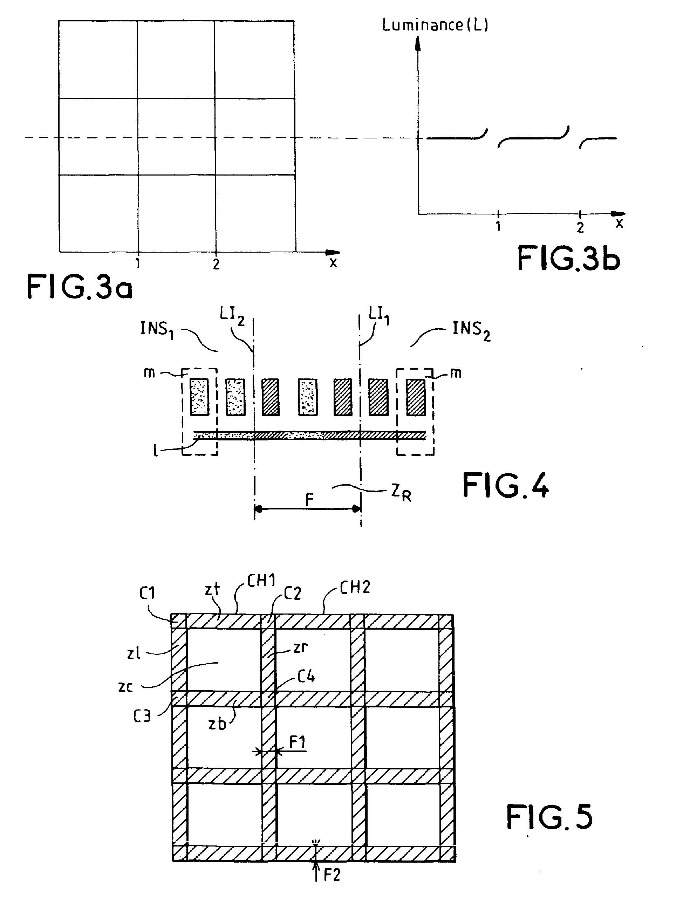

Si on applique une tension V aux bornes E et CE d'un élément pixel tel que schématiquement représenté sur la figure 2b, dans le cas d'un effet cristal liquide TN (Twisted Nematic), la luminance est très sensible à l'amplitude de cette tension. Comme illustré sur la figure 2a qui représente une courbe de luminance en fonction de l'amplitude de la tension, L=f(V), c'est dans la zone des niveaux de gris que la variation est très importante. Ainsi, avec des champs insolés selon l'état de la technique, on obtient une courbe de luminance sur la zone active qui est discontinue : au passage des frontières d'insolation, elle ne se raccorde pas. Cette cassure se traduit en pratique par une difficulté à restituer correctement les niveaux de gris. Sur un écran de visualisation, on peut ainsi observer visuellement les jonctions entre les différents champs d'insolation de la zone active, comme illustré sur la figure 3a, dû à des discontinuités de la courbe de luminance, par exemple du type représenté sur la figure 3b, selon l'axe des x. La qualité visuelle est donc dégradée.

On connaît un procédé selon lequel, pour réduire les effets des erreurs de positionnement des masques, les frontières entre les champs d'insolation sont déplacées d'un niveau d'insolation à un autre. En d'autres termes, les frontières ne sont pas reproduites aux mêmes endroits d'un niveau à l'autre. Ce faisant, on répartit les effets électro-optiques dus aux erreurs de positionnement en faisant glisser les frontières d'insolation sur la surface de la matrice, au lieu de les placer toujours au même endroit. On connaît aussi de la demande US2001/052966 A1, l'utilisation du système de projection pour réaliser une zone de recouvrement entre deux insolations, dans laquelle chaque insolation n'apporte qu'une partie de la dose d'insolation nécessaire à la réalisation d'un motif. Dans la demande JP2000 180894 A, des masques sont réalisés et disposés pour réaliser une zone de recouvrement entre deux insolations successives, chaque masque n'apportant pas tous les motifs de cellule dans la zone de recouvrement. Dans la demande US A 5 656 526, des masques sont dessinés qui ne sont pas à bords droits, de manière à ce que les champs d'insolation obtenus s'interpénètrent, pour obtenir une ligne de jonction de champ qui ne soit pas droite.

Dans l'invention, on a cherché une autre solution pour réduire de façon efficace les effets néfastes dus aux reports successifs du masque de zone active.

Dans l'invention, on a cherché un procédé de fabrication de matrice active qui permette d'améliorer de façon significative la qualité visuelle des écrans de visualisation.

L'idée à la base de l'invention est de reporter le masque de zone active de manière à ce qu'il existe une zone de recouvrement non nulle entre deux champs d'insolation successifs. Si on insole une première fois une partie de la zone active de la matrice, on positionne le masque pour l'insolation suivante de façon à recouvrir le premier champ insolé sur une certaine largeur, correspondant à la largeur d'une zone périphérique définie sur le masque. Dans cette zone périphérique du masque, le dessin à réaliser est incomplet ou flou.

Un masque (ou réticule) d'une matrice active peut se décrire comme un quadrillage, dans lequel chaque croisement d'une ligne et d'une colonne, est un point, un *dot* selon la terminologie anglo-saxonne, qui correspond à une cellule de matrice active. Ce point est en réalité un motif élémentaire du dessin (positif ou négatif) à réaliser sur une cellule pour un niveau de gravure considéré. On a ainsi un dessin de motifs identiques disposés selon un réseau croisé de lignes et de colonnes, qui correspond au réseau croisé de lignes et de colonnes de la matrice.

Selon l'invention, on définit sur ce masque une zone centrale et une zone périphérique. Le motif élémentaire est dessiné en chacun des points de la zone centrale du masque. Dans la zone périphérique, ce motif n'est pas dessiné en certains points, ces points étant préférablement répartis d'une façon aléatoire ou pseudo aléatoire.

On reporte le masque ainsi défini en faisant se recouvrir la zone périphérique entre deux champs d'insolation successifs. Chaque insolation apporte ainsi une partie des motifs dans les zones de recouvrement sur la matrice. De préférence, chaque insolation amène la même densité de motifs. Au final, le dessin des motifs dans les zones de recouvrement se complète. Dans les zones de recouvrement sur la matrice active, on a une répartition spatiale aléatoire des motifs apportés par les différentes insolations correspondant à la répartition aléatoire des points sans motifs entre les différentes parties de la zone périphérique du masque.

Par cette méthode d'insolation, on n'a plus une frontière nette entre deux champs d'insolation, correspondant à un report bord à bord, comme dans l'état de la technique, mais au contraire une frontière floue due à la largeur de la zone de recouvrement, et au caractère aléatoire ou pseudo-aléatoire de la répartition spatiale des motifs dans cette zone.

Le procédé de recouvrement selon l'invention s'applique notamment aux couches qui jouent un rôle direct dans les problèmes précités. Dans un exemple de matrice active à transistors TFT, comme illustré sur la figure 1b, il s'applique notamment aux trois niveaux de masquage des couches b, d et e, et c correspondant respectivement aux colonnes, aux canaux des transistors TFT et aux électrodes pixel (ITO). De façon plus générale, ce procédé peut être appliqué à chacun des niveaux de masquage de la matrice active, par exemple aux sept niveaux détaillés en référence à la figure 1 b.

Telle que revendiquée, l'invention concerne donc un procédé de fabrication d'une matrice active comprenant une zone active comportant un ensemble de cellules disposées selon un réseau croisé de lignes et de colonnes, ledit procédé comprenant au moins une étape de dépôt d'une couche d'un matériau et d'insolation de cette couche, pour insoler par masque un motif identique de cellule en chaque point d'intersection d'une ligne et d'une colonne du réseau, avec une zone de recouvrement de largeur non nulle entre deux champs d'insolation successifs, chaque insolation n'apportant qu'une partie des motifs de cellule dans ladite zone de recouvrement, caractérisé en ce qu'un même masque est reporté plusieurs fois suivant les deux directions du réseau de lignes et de colonnes pour couvrir l'ensemble de la zone active, ledit masque comprenant une partie périphérique dans laquelle des motifs ne sont pas réalisés en certains points, autour d'une zone centrale dans laquelle tous les motifs sont réalisés, la largeur de la zone de recouvrement entre deux champs d'insolation successifs dans une direction de report correspondant à une largeur de ladite zone périphérique du masque, et la répartition des motifs dans ladite partie périphérique étant définie en fonction d'un mode d'adressage des lignes et colonnes, avec inversion de polarité, de sorte que chaque insolation amène dans ladite zone de recouvrement autant de motifs de cellule dans chaque polarité.

L'invention concerne aussi un dispositif de visualisation ou de détection électro-optique à matrice active obtenue selon un tel procédé.

L'invention concerne aussi un masque pour insoler un dessin formé de motifs identiques de cellules d'une matrice active disposées selon un réseau croisé de lignes et de colonnes, chaque motif étant dessiné au point d'intersection d'une ligne et d'une colonne, caractérisé en ce que ledit masque comprend une partie périphérique autour d'une zone centrale, et en ce que le dessin est incomplet dans la zone périphérique, des motifs n'étant pas réalisés en certains points de cette zone, et en ce que la répartition des motifs dans ladite zone périphérique est définie en fonction d'un mode d'adressage des lignes et colonnes, avec inversion de polarité, de sorte que chaque insolation amène dans ladite zone de recouvrement autant de motifs de cellule dans chaque polarité.

D'autres avantages et caractéristiques de l'invention apparaîtront plus clairement à la lecture de la description qui suit, faite à titre indicatif et non limitatif de l'invention et en référence aux dessins annexés, dans lesquels :
- les figures 1a à 1f déjà décrites représentent des champs insolés en zones active et périphérique d'écrans à matrice active, des vues de dessus et en coupe longitudinale d'une cellule de matrice active à transistors à couches minces TFT et des masques utilisés selon des procédés de fabrication connus;
- les figures 2a et 2b déjà décrites représentent respectivement un schéma d'un élément pixel et une courbe de luminance de cet élément pixel en fonction de l'amplitude de la tension V réelle appliquée aux bornes de l'élément pixel,
- les figures 3a et 3b déjà décrites représentent le défaut dit de *stepper-pattern* tel qu'on peut l'observer (fig.3a) sur un dispositif de visualisation obtenu selon un procédé de l'état de la technique dû à des discontinuités dans la courbe de luminance au niveau des frontières (fig.3b),
- la figure 4 représente un schéma de principe d'un procédé d'insolation par recouvrement de champs selon l'invention,
- la figure 5 illustre de façon schématique les champs d'insolation réalisés selon l'invention sur un niveau donné d'une matrice active,
- la figure 6 est une image d'un masque de zone active selon l'invention,
- la figure 7 illustre le principe de réalisation de masques d'insolation selon l'invention,
- les figures 8a à 8d représentent des échantillons des parties respectivement supérieure, inférieure, latérale droite et de coin supérieur droit de la zone périphérique d'un masque de zone active selon l'invention, destiné à la fabrication d'une matrice active comprenant une structure de filtres colorés de type "Stripe",
- les figures 9a et 9b représentent schématiquement une structure de filtres colorés de type "Quad".
- les figures 10a à 10d représentent schématiquement des réticules pour matrice active associés à un niveau de fabrication donné, sur lesquels sont dessinés les différents masques nécessaires pour couvrir la zone active et la périphérie selon un procédé conforme à l'invention,
- la figure 11 montre les champs insolés correspondants sur la matrice active,
- les figures 12a à 12c montrent un autre exemple de jeu de réticules par lesquels on peut mettre en oeuvre l'invention, et
- la figure 13 montre les champs insolés correspondants sur la matrice active.

Le principe d'insolation selon l'invention est illustré sur la figure 4, qui montre une zone de recouvrement Z_{R} de largeur F de deux champs d'insolation INS₁ et INS_{2,}. Ces champs d'insolation ont été obtenus à partir d'un masque, pour reproduire un motif m identique en chaque point de la matrice active.

Dans chaque champ d'insolation on a une zone dans laquelle tous les motifs m sont réalisés, et une zone en périphérie, dans laquelle certains motifs seulement sont réalisés. On réalise une première insolation du masque, qui donne un premier champ d'insolation INS₁. On réalise une deuxième insolation du même masque, en plaçant le masque de façon à ce que la zone périphérique du masque vienne en superposition sur la zone périphérique du champ précédemment insolé. Sur la figure, on a représenté la limite latérale droite LI₁ de l'insolation. On vient superposer à la partie périphérique latérale droite du premier champ INS₁, la partie périphérique latérale gauche du masque, pour réaliser le deuxième champ d'insolation INS₂. La zone de recouvrement Z_{R} sur la matrice active, est ainsi délimitée à droite par la limite d'insolation LI₁ du premier champ, et à gauche par la limite d'insolation LI₂ du deuxième champ INS₂. Dans cette zone de recouvrement, on a des motifs m amenés par la première insolation, indiqués en moucheté sur la figure, et des motifs m amenés par la deuxième insolation, indiqués en rayé. Cette zone de recouvrement a une largeur F. Dans un exemple pratique, pour une matrice active de 600 par 600, la largeur de la zone de recouvrement peut correspondre à une vingtaine de lignes (parties périphériques supérieure et inférieure) ou de colonnes (parties périphériques latérales).

De préférence, pour favoriser la continuité des motifs dans la zone de recouvrement, par exemple pour assurer la continuité des lignes I sur la figure 4, on utilise une technique de raccordement dite de "*stitching*" utilisée habituellement sur les bords des masques. Cette technique consiste à dépasser un peu certaines des cotes réelles de certains motifs dans le dessin du masque, pour compenser les erreurs de repositionnement dans la zone de recouvrement. Le masque étant insolé deux fois dans cette zone de recouvrement, après développement sur la dalle de matrice active, on a les mêmes cotes partout.

Sur la figure 5, on a représenté schématiquement des champs d'insolation CH1, CH2 obtenus sur un niveau de masquage de matrice active selon l'invention. Les zones de recouvrement sont indiquées en rayé sur la figure. Pour un champ d'insolation donné, CH1 par exemple, les zones de recouvrement comprennent les parties périphériques, autour de la zone centrale zc, à savoir, les parties latérales gauche zl et droite zr, et les parties supérieure zt et inférieure zb, ces parties ayant en commun deux à deux un des quatre coins c1, c2, c3, c4 du champ. Dans la zone centrale, la densité de motifs amenée par une insolation est de 1, dans les zones de recouvrement, elle est inférieure. Le masque de zone active a été reporté 9 fois dans cet exemple, en recouvrant à chaque fois une zone du champ d'insolation précédent. Sur les bords de la matrice active, différentes techniques de recouvrement peuvent être utilisées, pour amener les motifs manquants. On peut par exemple prévoir des masques supplémentaires pour les bords, ou utiliser au moins certains des masques des circuits périphériques, comme on le détaillera plus loin.

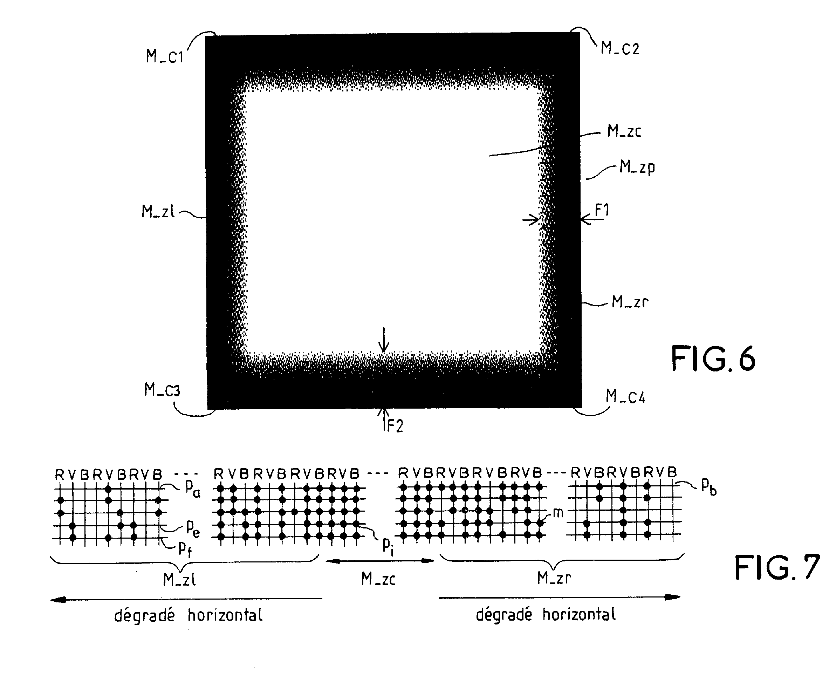

La figure 6 montre l'image d'un masque d'insolation selon l'invention. C'est habituellement une plaque de verre, sur laquelle du chrome a été déposé puis gravé. Dans l'exemple, les zones ou points noirs, où le chrome n'a pas été enlevé, sont les zones ou points sans motifs. La zone centrale M-zc apparaît ainsi entièrement blanche. Dans la zone périphérique M-zp, tout autour de la zone centrale, il manque des motifs. Cette zone périphérique M-zp comprend des parties latérales gauche M-zl et droite M-zr et des parties supérieure M-zt et inférieure (M-zb). Ces parties ont en commun deux à deux un coin parmi les quatre coins du masque M-c1, M-c2, M-c3, M-c4.

Dans cette zone périphérique, les points noirs, sans motifs, sont répartis aléatoirement ou pseudo-aléatoirement entre les différentes parties de la zone périphérique.

Sur la figure 7, on a détaillé un échantillon de dessin du masque, qui correspond à une bande centrale longitudinale de ce masque. Le réseau croisé de lignes et de colonnes correspond à celui de la matrice active. Il constitue la trame de dessin du masque. En chacun des points d'intersection, ou points pᵢ, on a normalement un motif m de cellule, qui correspond au niveau de masquage concerné. Dans l'exemple, ce motif m est représenté sous la forme d'un rond plein. Dans la zone centrale M-zc, on a un motif sur chaque point. Dans les partie périphériques à gauche M-zl et à droite M-zr, il y a des points sans motifs, tels que pₐ, p_{b}.

Le dessin de ces parties M-zl et M-zr est tel que si on les superposent, les motifs se complètent. Si on reprend la figure 5, on comprend que dans les zones de recouvrement, en dehors des coins, l'ensemble des motifs m est amené par deux insolations, une insolation d'une partie périphérique du masque, et une autre insolation de la partie périphérique opposée du masque : ces parties sont complémentaires. Dans chaque coin, les motifs sont amenés par quatre insolations du masque, par chacun des coins du masque. Ainsi, les dessins des coins se complètent. En dehors des coins, les parties périphériques du masque latérales gauche et droite, respectivement supérieure et inférieure sont complémentaires deux à deux : le dessin de l'une est le négatif de l'autre, en dehors des coins.

De préférence, on prévoit que ces parties ont chacune une densité de motif sensiblement égale à ½, et à ¼ dans les coins du masque. Ainsi dans une zone de recouvrement, la contribution de chaque insolation à la construction du dessin complet est sensiblement égale.

De préférence la fonction de répartition aléatoire des points sans motifs sur les parties périphériques du masque suit une loi de croissance ou décroissance selon les lignes (parties latérales) et les colonnes (parties supérieure et inférieure). Visuellement cela se traduit par un dégradé dans la répartition des points noirs : dégradé vertical pour les parties supérieure et inférieure, horizontal pour les parties latérales de la zone floue et dégradé vertical et horizontal dans les coins. Partant de l'extérieur du masque vers la zone centrale, on a ainsi de moins en moins de points sans motifs. Cela est très visible sur la figure 6 : aux abords de la zone centrale, les points sans motifs sont peu nombreux, ce qui se traduit visuellement par un moucheté noir. Plus on approche des bords extérieurs du masque, plus les points sans motifs sont nombreux, ce qui se traduit visuellement par un moucheté blanc. De préférence, on prévoit que cette fonction de répartition aléatoire des points sans motifs est une fonction décroissante (ou croissante) selon les lignes ou les colonnes. Si on applique par exemple une fonction de croissance linéaire, dans les parties périphériques supérieure et inférieure, sur la première ligne jouxtant la zone centrale, il manquera par exemple un motif, sur la deuxième il en manquera deux, sur la troisième il en manquera 3,...(dégradé vertical). Dans les parties périphériques latérales gauche et droite, c'est un dégradé horizontal, comme illustré sur la figure 7. D'autres fonctions de décroissance peuvent être appliquées.

Dans le cas d'une matrice active avec une structure de filtres colorés, la fonction de répartition aléatoire des points sans motifs tient compte de préférence de l'arrangement des filtres colorés sur la matrice En effet, selon le filtre coloré associé, un élément pixel d'une cellule aura une luminance différente. Par exemple, on sait que les éléments pixels associés à un filtre vert sont beaucoup plus lumineux que ceux associés à un filtre rouge ou bleu. Si on enlève trop de motifs de cellules associées à une même couleur de filtre, on risque de dégrader les performances électro-optique du dispositif de visualisation. Prenons par exemple la partie périphérique latérale droite du masque. Supposons que la fonction de répartition appliquée dans cette partie se traduise par principalement ne pas réaliser des motifs de cellules associées sur la matrice à des filtres verts. Les motifs de ces cellules "vertes" sont apportés par une autre insolation du masque, par la partie périphérique latérale gauche complémentaire. En procédant ainsi, on risque fort de voir apparaître une différence de luminance dans cette zone de la matrice active par rapport au reste de l'écran.

Ainsi, dans l'invention, on prévoit de préférence de répartir les points sans motifs sur la zone périphérique du masque en sorte que dans les motifs amenés par une insolation du masque, il manque autant de motifs de cellules dans chaque couleur. De cette façon on obtient des qualités visuelles cosmétiques optimum.

Prenons une matrice active comprenant une structure de filtres colorés de type "stripe". Dans une matrice ayant une telle structure de filtres, un point image comprend trois éléments pixels placés consécutivement sur la même ligne, avec un élément pixel associé à un filtre rouge R, un élément pixel associé à un filtre V et un élément pixel associé à un filtre bleu B, cette structure R, V, B étant répétée tout au long de la ligne et d'une ligne à l'autre. Si on applique le principe de l'invention à ce cas, dans chaque ligne, à chaque fois qu'on enlève un motif associé à une des couleurs, on enlève dans la même ligne un motif associé à chacune des autres couleurs.

De préférence, toujours pour améliorer la qualité visuelle des écrans, on prévoit de ne pas enlever les motifs par points image. En effet, dans une zone de recouvrement, les motifs seraient alors tous amenés par une insolation par groupe de trois motifs, correspondant à la structure des filtres, ce qui visuellement pourrait donner une structure trop grossière. Ainsi, on prévoit que la répartition des motifs amenés par une insolation dans la zone de recouvrement est telle que pour chaque point image dans la zone périphérique, une insolation ne peut pas amener que 0 ou n=3 motifs, mais amener 0, 1, 2 ou 3 motifs.

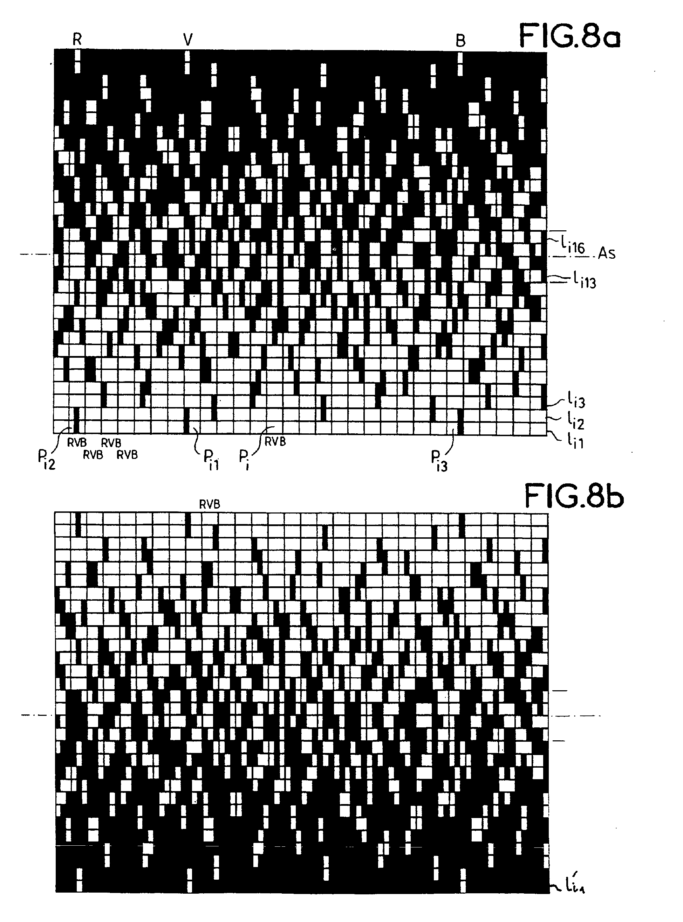

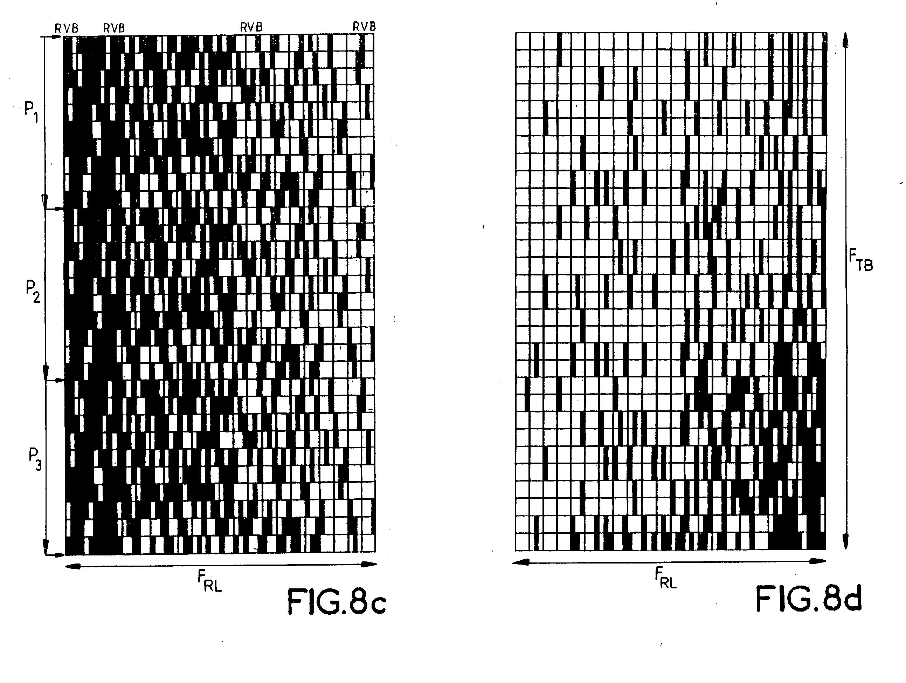

C'est ce que l'on peut voir sur les figures 8a à 8d, qui représentent de façon schématique des échantillons de dessin de la zone périphérique d'un masque selon l'invention. Plus précisément, la figure 8a représente un échantillon de la partie supérieure, la figure 8b, l'échantillon complémentaire de la partie inférieure, la figure 8c, un échantillon de la partie latérale droite et la figure 8d, un coin supérieur droit. Ces échantillons se présentent sous la forme d'un quadrillage. Chaque rangée de carreaux correspond à une ligne de cellules sur la matrice. Chaque colonne de carreaux correspond à trois colonnes de cellules sur la matrice, correspondant à la structure R, V, B des filtres. Chaque carreau du quadrillage correspond ainsi à un point image Pi comportant trois cellules successives, sur la même ligne : une cellule à filtre rouge, une cellule à filtre vert V et une cellule à filtre bleu B.

La rangée li₁ en bas du quadrillage de la figure 8a correspond à la dernière ligne de la zone périphérique du masque, avant la partie centrale (non représentée). Dans cette rangée li₁, il manque un motif de cellule à filtre rouge, un motif de cellule à filtre vert et un motif de cellule à filtre bleu, chacun pris sur un groupe de points du masque correspondant à des points image différents Pi₁, Pi₂ et Pi₃ de la matrice. Sur la ligne suivante li₂, il manque deux motifs de cellule à filtre rouge R, deux motifs de cellule à filtre vert V et deux motifs de cellule à filtre bleue B. Et ainsi de suite. Le fait que la cellule soit à filtre rouge, vert ou bleu dépend de sa position sur la matrice, en fonction de la structure des filtres colorés de la matrice.

Sur l'échantillon complémentaire, représenté sur la figure 8b, la rangée li'₁ a un dessin complémentaire du dessin de la rangée li₁.

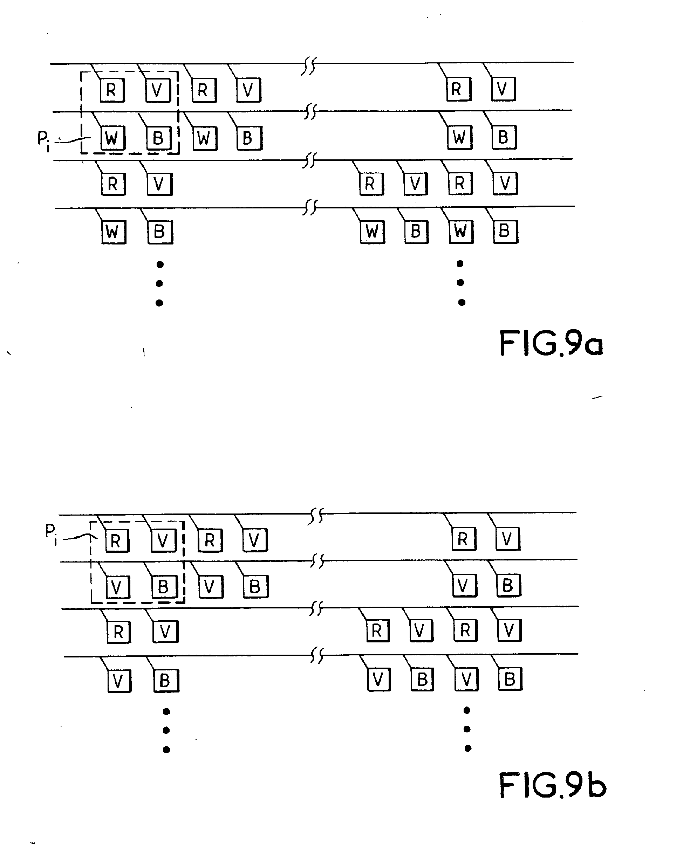

Un autre exemple de structure de filtre coloré est représenté sur les figures 9a et 9b. Ce sont des structures de type "Q*uad*". Chaque point image comprend quatre éléments pixels disposés sur deux colonnes successives, deux éléments pixels sur une même ligne et deux éléments pixels sur la ligne suivante. Dans la matrice, sur les lignes paires, les éléments pixels sont alternativement colorés rouge R et vert V, tandis que sur les lignes impaires, les éléments pixels sont alternativement colorés vert V et bleu B (figure 9b) ou blanc W et bleu B (figure 9a).

On applique les mêmes principes de répartition des points sans motifs précédemment exposés pour élaborer le dessin de la zone périphérique du masque, pour avoir la meilleure qualité optique.

Si on prend la structure quad de la figure 9a, un masque selon l'invention aura un dessin de zone périphérique tel qu'une insolation de cette zone périphérique amènera autant de motifs dans chacune des couleurs par ligne. En d'autres termes, cette insolation amènera autant de "rouge" que de "vert " dans les lignes paires et autant de "vert" que de "bleu" dans les lignes impaires (figure 9a).

En outre, de même que précédemment, dans le dessin de la zone périphérique les points sans motifs sont de préférence répartis de façon à ce qu'une insolation de cette zone périphérique ne puisse pas amener pour chaque point image que 0 ou n=2 motifs sur la ligne, mais 0, ou 1 ou n=2 motifs. En d'autres termes, si on prend les lignes "paires", pour chaque point image dans la zone de recouvrement, une insolation de la zone périphérique amène 0 motif, ou un motif (rouge ou vert) ou les deux motifs (rouge et vert).

Il existe d'autres structures de filtres colorés. Dans tous les cas, pour réaliser une zone périphérique selon l'invention, la fonction de répartition des points sans motifs doit tenir compte de la structure des filtres le long des lignes de la matrice, pour avoir le moins d'effets négatifs, notamment eu égard aux différences de luminance apportées par les insolations successives.

Une définition générale de la règle de sélection de points sans motifs, pour le dessin de la zone périphérique, peut s'énoncer comme suit :

Une structure de filtres colorés d'une matrice comprend n couleurs par ligne : n=2 couleurs pour la structure quad, n=3 couleurs dans la structure RVB, pour les deux exemples cités.

Ces règles peuvent se traduire sur le dessin de la zone périphérique de la façon suivante : en regroupant les points par série de n points successifs selon les lignes, correspondant à une matrice à structure périodique de n filtres colorés selon les lignes, et en attribuant un rang 1, 2, ...n à chaque point dans chaque série, la répartition des points sans motifs dans la zone périphérique (M-zp) du masque est telle qu'il y a autant de points sans motifs dans chaque rang.

Avantageusement, dans les séries de n points, on ne peut pas avoir que des points sans motifs ou que des points avec motifs: dans chaque série, il peut manquer 0, 1, 2 ou n motifs.

Dans le but d'avoir la plus grande qualité visuelle possible, le dessin de la zone périphérique du masque doit aussi de préférence tenir compte du mode d'adressage des lignes de la matrice.

Il est bien connu que les modes d'adressage les plus courants, sont les modes d'adressage en inversion ligne, colonne ou point. Si on prend le mode d'adressage en inversion ligne, dans une trame, la polarité de la tension appliquée est inversée à chaque ligne, et inversée de trame en trame. En inversion colonne, la polarité est inversée à chaque colonne et inversée de trame en trame. En inversion point, on a un mélange des deux. Ces modes d'adressage permettent d'empêcher l'écrêtage du champ électrique en prévenant la migration de charges. Ces divers modes d'adressage sont utilisées avec des matrices actives sans filtres colorés. Ils sont aussi utilisés pour des matrices actives avec une structure de filtres de type stripe. Avec des structures de filtres quad, on utilise habituellement un autre type d'adressage, qui est le mode d'adressage en inversion double ligne : les deux premières lignes sont dans une polarité, les deux suivantes dans l'autre et ainsi de suite.

Si on ne se préoccupe pas du mode d'adressage dans la création du dessin de la zone périphérique, on risque d'avoir des phénomènes de papillotement. Prenons par exemple le mode inversion point. Dans une trame, on a une inversion de polarité à chaque point sur chaque ligne, et une inversion de ligne en ligne. Si on ne tient pas compte de ces propriétés dans la répartition des points sans motifs, on pourrait très bien avoir dans une zone de recouvrement sur la matrice active, des motifs de cellules "positives" qui seraient en majeure partie amenés par l'insolation d'une partie périphérique du masque, et des motifs de cellules "négatives" qui seraient en majeure partie amenés par l'insolation de la partie périphérique complémentaire du masque. Les différences de luminance entre les deux insolations sont alors amplifiées, et peut entraîner un phénomène de papillotement.

Selon l'invention, on prévoit de grouper les points sans motifs au moins par paires, correspondant à deux cellules de polarités opposées dans la matrice, de manière à amener à chaque insolation autant de motifs de cellules dans une polarité que de motifs de cellules dans l'autre polarité. La position de ces points est fonction du mode d'adressage des lignes et/ou de colonnes.

La position de ces points est aussi fonction de la structure de filtres colorés dans le cas d'une matrice couleur. En effet, on peut obtenir un avantage supplémentaire, qui est de mieux compenser les différences de luminance dues aux différentes polarités dans les trames, lorsque les points sans motifs groupés par paires correspondent à des cellules de polarité opposée mais associées à la même couleur (donc de même luminance).

Si on considère une matrice active à structure de filtres colorés quelconque. Si je prends une cellule quelconque de la matrice : il y a au moins une cellule proche voisine de polarité opposée associée à la même couleur, selon la périodicité horizontale et/ou verticale de la structure de filtre et selon le mode d'inversion de trame. On en déduit aisément pour chaque type de matrice active, une règle de groupement deux par deux des points sans motifs.

Dans le cas d'une matrice à structure RVB par exemple, avec un mode d'adressage en inversion colonne, une cellule la plus proche voisine de polarité opposée et de même couleur qu'une cellule par exemple une cellule rouge, se situe sur la même ligne que cette cellule : c'est la cellule rouge suivante ou précédente dans la ligne, comme illustré dans le tableau suivant :

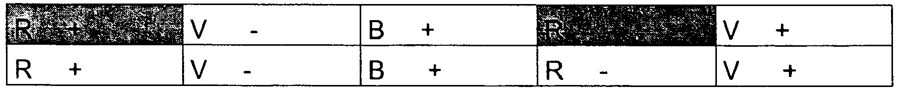

Dans le cas d'une matrice à structure RVB pour un mode d'adressage en inversion ligne ou point, une cellule la plus proche voisine de polarité opposée et de même couleur qu'une cellule, par exemple une cellule verte, se situe sur la même colonne que cette cellule : c'est la cellule verte sur la ligne précédente ou la ligne suivante , comme illustré dans le tableau suivant :

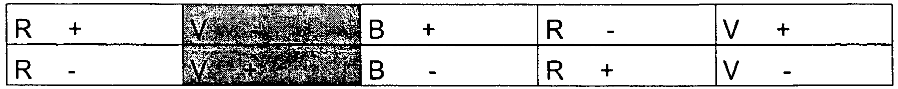

Dans le cas d'une matrice à structure quad, dont on a vu que le mode d'adressage était le mode d'inversion double ligne, une cellule la plus proche voisine de polarité opposée et de même couleur qu'une cellule, par exemple une cellule rouge, se situe sur la même colonne que cette cellule, et sur la ligne suivante de même parité : c'est une cellule rouge sur la même colonne, et sur la ligne paire suivante ou précédente, comme illustré sur le tableau suivant :

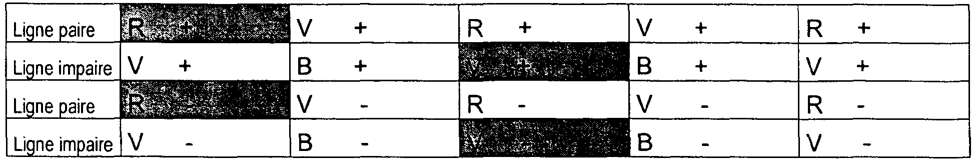

Dans le deuxième exemple, qui correspond à une matrice active à structure RVB (stripe) en mode inversion ligne ou point, cela revient simplement sur le dessin du masque à grouper les points sans motifs au moins deux par deux verticalement, selon les colonnes. De cette façon, on réduit de façon simple et efficace les problèmes liés aux modes d'adressage, plus particulièrement en inversion ligne ou point: La règle de dessin associée se traduit par une sélection par paires verticales : la sélection d'un point dans une ligne entraîne dans la ligne suivante la sélection du point sur la même colonne. Sur les échantillons des figures 8a, 8b, cela se traduit par des rectangles noirs (points sans motifs) sur au moins deux carreaux verticalement. Par complémentarité, on a aussi des rectangles blancs (points avec motif) sur au moins deux carreaux verticalement.

Le même dessin est applicable dans le cas d'une matrice sans filtres colorés, en mode inversion ligne ou point.

Dans le cas d'une matrice sans filtres colorés, en mode inversion colonne, la sélection des points sans motifs se fait par paires horizontales de points successifs.

Dans les autres cas, la règle de dessin correspondant à la règle de sélection est fonction de la périodicité intrinsèque à la structure des filtres sur la matrice et au mode d'adressage de la matrice.

Ainsi, l'élaboration du dessin dans la zone périphérique du masque dépend de différentes règles de conception des masques et des différentes règles de répartition des points sans motifs précédentes, dont on a pu vérifier qu'elles permettaient d'obtenir des qualités visuelles optimales. En particulier, cette élaboration dépend des fonctions de dégradé horizontal, vertical que l'on veut appliquer, du mode d'adressage de la matrice, et le cas échéant, de la structure des filtres colorés. Les largeurs des parties latérales et supérieure/inférieure peuvent être différentes, les contraintes étant généralement différentes sur ces parties.

En pratique, l'élaboration du dessin dans la zone périphérique du masque, tout autour de la zone centrale, peut être simplifiée par des règles de conception simples.

Si on prend la figure 8a par exemple, dans cet échantillon, on a un effet miroir inverse du dessin par rapport à l'axe A1 qui coupe l'échantillon en deux longitudinalement, sauf sur les quelques lignes autour de cet axe, les li₁₃ à li₁₆dans l'exemple.

On peut aussi répéter un dessin aléatoire. C'est ce que l'on peut observer sur l'échantillon d'une partie périphérique latérale gauche illustré sur la figure 8c : le même dessin aléatoire est répété 3 fois (p1, p2, p3) verticalement.

Enfin, la répartition des points sans motifs (ou avec motifs, par complémentarité) est fonction de la densité de motifs recherchée pour chaque insolation. De préférence, pour avoir un meilleur effet flou en terme de luminance, on cherche à ce que chaque insolation d'une partie périphérique dans une zone de recouvrement sur la matrice amène sensiblement la même densité de motifs. En pratique, on prévoit que ces densités sont sensiblement égales : on a alors une densité de motifs dans les parties périphériques sensiblement égale à ½ excepté dans les coins, où elle est sensiblement égale ¼.

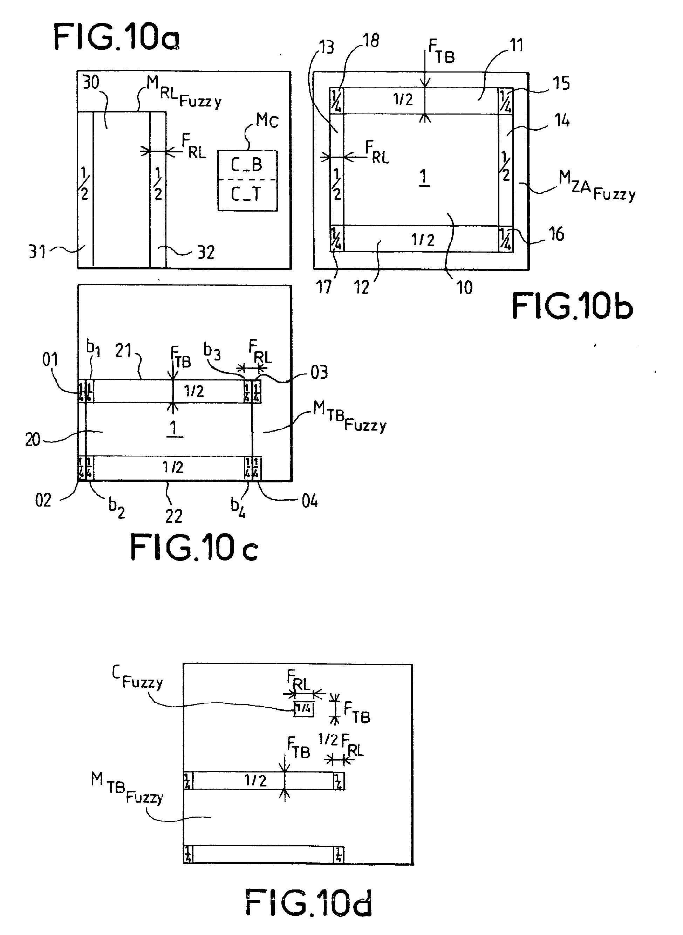

Ainsi, comme représenté sur la figure 10b, un masque de zone active MZA_{FUZZY} selon un mode de réalisation préféré de l'invention se découpe en des zones de densité de motifs différentes : la zone centrale 10 avec une densité de 1 des motifs. Les zones supérieure 11, inférieure 12, latérale gauche 13, latérale droite 14, avec une densité de ½, et les quatre coins 15, 16, 17 et 18, avec une densité de ¼. Pour les zones de densité ½, il faut deux insolations pour avoir le dessin complet, pour les zones de densité ¼_{,} il en faut quatre.

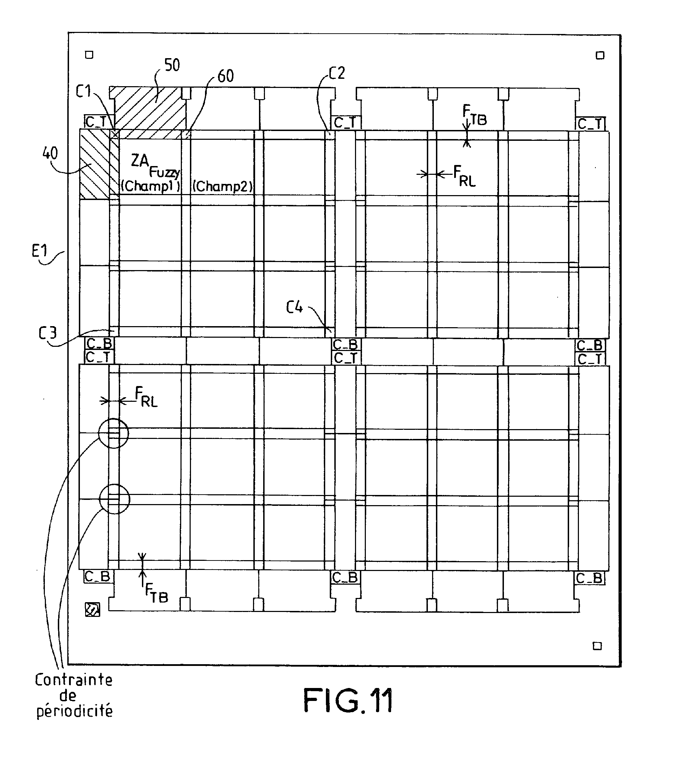

Si on reporte ce masque selon le procédé de l'invention, on couvre la zone active de la matrice, par exemple en neuf insolations par matrice, comme représenté sur la figure 11. Après ces neuf insolations, les motifs ne sont cependant pas tous au complet sur les bords, sur une largeur correspondant à la largeur des zones floues du masque : F_{RL} sur les bords droit et gauche de la zone active, F_{TB} sur les bords supérieur et inférieur de la zone active.

Il y a ainsi plusieurs façons de compléter ces bords, en utilisant les masques de périphérie et/ou des masques spécifiques. En effet, le défaut dit de "stepper pattern" est peu visible en bord d'écrans. Il est donc possible d'utiliser d'autres masques pour compléter les bords que le masque de zone active. Pour un type de matrice donnée, le choix d'une solution sera principalement motivé par un compromis entre la place disponible en périphérie, la périodicité du dessin flou en comparaison de la celle des dessins périphériques, et le nombre d'insolation (shot) par niveau que l'on cherche en général à minimiser, pour optimiser les temps de fabrication.

Un premier exemple de réalisation est illustré sur les figures 10a à 10d en combinaison avec la figure 11. Les figures 10a à 10d représentent des réticules sur lesquels on a réalisé des masques qui permettent de mettre en oeuvre un procédé de recouvrement selon l'invention. La figure 11 représente les champs insolés avec ces masques sur la matrice.

Sur la figure 11, les champs insolés dans la zone active sont obtenus par reports successifs, avec recouvrement, du masque de zone active MZA_{FUZZY} représenté sur la figure 10b. Si on prend la matrice active référencée E1, la zone grisée montre les bords de la zone active qui ne sont insolés qu'une seule fois à travers le masque MZA_{FUZZY}. Dans cette zone grisée, on a donc une densité de motifs de ¼, sauf dans les quatre coins c1, c2, c3 et c4 de la matrice où la densité des motifs n'est que de ¼.

Ces motifs sont ici complétés aux moyens des masques de périphérie. Ces masques sont détaillés sur les figures 10a et 10c.

Le masque latéral gauche/droite de périphérie, noté MTB_{FUZZY} disposé verticalement sur la figure 10a, comprend une partie centrale 30 qui correspond au dessin habituel des circuits de périphérie, et deux zones 31 et 32 de part et d'autre qui correspondent au dessin flou à compléter à gauche et à droite de la matrice. Ces deux zones verticales ont la même largeur que les zones qu'elles doivent compléter, soit F_{RL}, et une densité de motif de ½.

Le masque supérieur/inférieur de périphérie, noté MTB_{FUZZY} disposé horizontalement sur la figure 10c, comprend une partie centrale 20 qui correspond au dessin habituel des circuits de périphérie, et deux zones horizontales de part et d'autre qui correspondent au dessin flou à compléter en haut ou en bas de la matrice. Ces deux zones horizontales ont la même largeur que les zones qu'elles doivent compléter, soit F_{TB}, et une densité de motif ½, excepté à chaque extrémité, en b1, b2, b3 et b4 sur la figure, où cette densité est d'1/4. En outre, ces zones débordent de chaque côté pour former une oreille avec une densité de ¼. Ces oreilles sont notées o1, o2, o3, o4 sur la figure. A chaque extrémité, on a ainsi une densité de ¼ sur une longueur F_{RL}. Ce masque de périphérie est reporté le long des bords périphériques supérieur et inférieur de la matrice en sorte qu'il y ait recouvrement des extrémités de densité 1/4. La zone 21, respectivement 22 de ce masque complète la zone 12, respectivement 11 du masque de zone active. La zone (o2 +b2) se complète à 1/2 avec la zone (b4+o4) ; la zone (o1+b1) se complète à ½ avec la zone (b3+o3).

Le masque de coin de périphérique Mc est inchangé par rapport aux procédés de l'état de la technique.

L'exemple représenté sur la figure 11, correspond à une mise en oeuvre de l'invention dans laquelle la zone floue droite/gauche sur les bords de la zone active chevauche la zone active et la zone périphérique.

Si on se réfère à la figure 11, la contribution du masque latéral de périphérie MRL_{FUZZY} est indiquée en rayé dans la zone 40. Elle complète le bord grisé en apportant une densité de ½ des motifs. Dans le coin c1, il manque encore ¼ des motifs. C'est le rôle des oreilles dans le masque supérieur/inférieur de périphérie d'apporter ces motifs manquants. La contribution de ce masque est indiquée en rayé dans la zone 50. Dans l'exemple, le coin c1 est ainsi réalisé avec une contribution d'¼ amenée par la zone 18 du masque M_{ZAFUZZY}, une contribution d'½ amenée par la zone 32 du masque MRL_{FUZZY} et une contribution d'¼ amenée par o2 + b2 du masque MTB_{FUZZY}.

La zone 60 sur la figure 11 correspond à un coin droit d'un champ 1 de zone active et gauche du champ 2 de zone active réalisé à côté. La densité des motifs apportée dans cette zone par le masque MZA_{FUZZY} insolé deux fois (champs 1 et 2, figure 11) est de ½. Le complément des motifs est alors apporté pour ¼, par b4 + o4 par une première insolation du masque MTB_{FUZZY} (champ 1) et pour ¼ par o2 + b2 par une deuxième insolation du masque MTB_{FUZZY} (champ 2).

Une variante de réalisation est représentée sur la figure 10d. Dans cette variante, le masque de périphérie supérieur/inférieur ne comporte plus d'oreille. Il se positionne bord à bord, le long des bords périphériques supérieur et inférieur, et complète la zone grisée de zone active le long de ces bords à ½. Les coins c1, c2, c3, c4 et les zones telles que 60, en bordure dans la zone active, correspondant aux coins en zone de recouvrement des champs, sont alors complétés à ¼ par un masque supplémentaire spécifique, noté C_{FUZZY}, de longueur 1 fois F_{RL}. Dans cette variante, on augmente cependant le nombre d'insolations à réaliser par niveau.

D'autres variantes sont possibles. En particulier, si on a de la place, on peut éloigner un peu les éléments de circuit périphérique de la matrice, en sorte qu'au lieu de positionner les masques de zone active au bord de la zone active, on va les faire chevaucher cette limite, en sorte que la zone floue du masque se retrouve insolée dans la partie périphérique. Une deuxième insolation, avec un masque de zone périphérique adapté, permet d'annuler ces motifs.

Un des problèmes liés à l'utilisation des masques de périphérie est qu'il faut que ces masques s'accordent bien avec le dessin aléatoire à compléter. En d'autres termes, le dessin aléatoire qu'un masque de périphérie doit compléter doit être toujours le même. Si le dessin aléatoire est périodique, il faut que la longueur du masque de périphérie soit compatible avec cette périodicité. Dans l'exemple de la figure 11, la contrainte de périodicité s'applique le long des colonnes, c'est à dire verticalement. Dans d'autres exemples, on pourrait aussi avoir une contrainte de périodicité le long des lignes.

Lorsque le dessin flou déborde sur la partie périphérique, il faut encore que l'on est assez de place en périphérie.

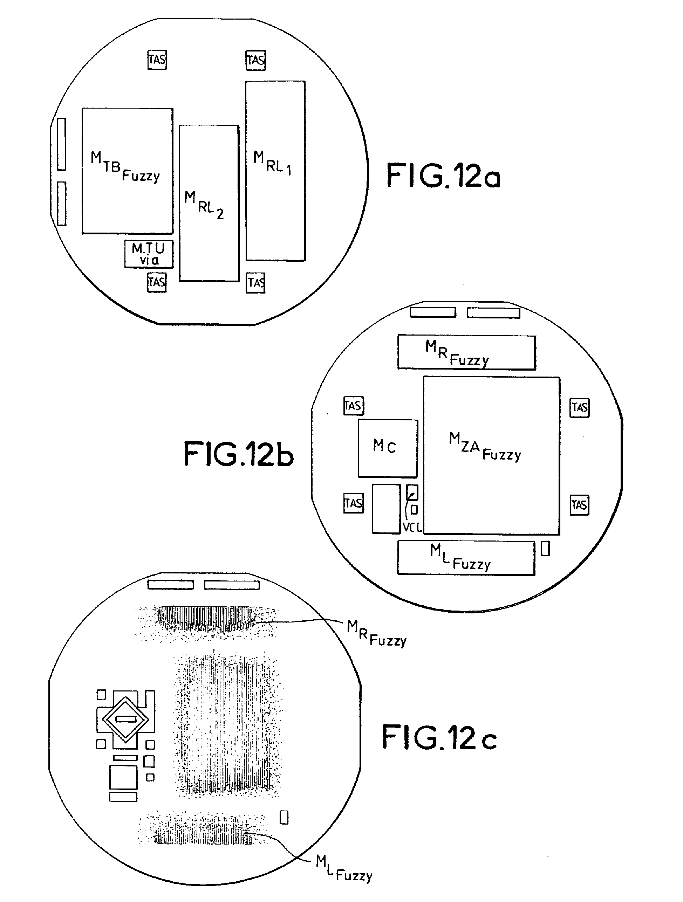

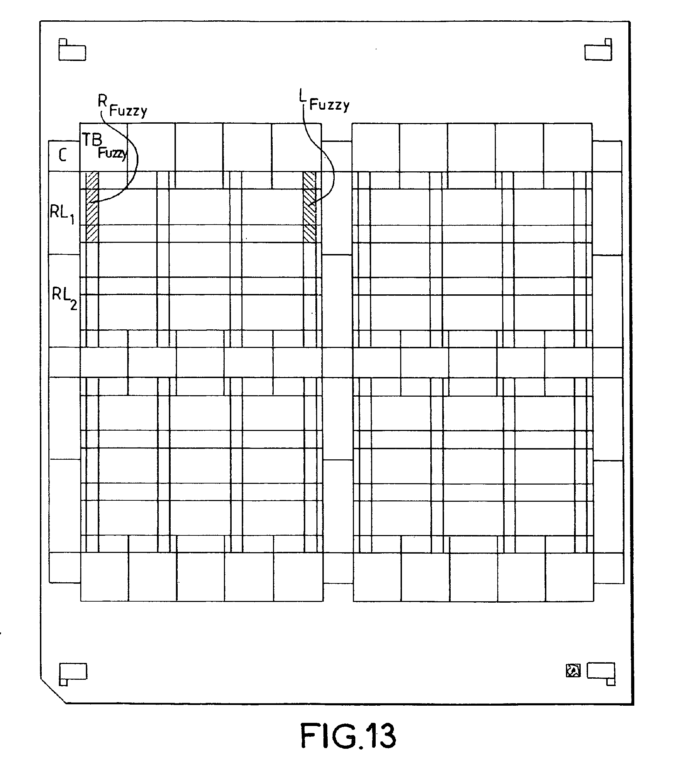

Lorsqu'il n'est pas envisageable d'utiliser les masques de périphérie, ou seulement une partie de ces masques, par exemple, lorsque l'on utilise seulement le masque de périphérie supérieur/inférieur, on utilise des masques spécifiques pour compléter les bords. Un telle variante est illustrée sur les figures 12a à 12c et 13.

Sur la figure 12a, on a un premier réticule qui comporte un masque de périphérie supérieur/inférieur, du type flou, comme dans le cas précédent, noté MTB_{FUZZY}, et deux masques de périphérie latérale MR_{L1} et MRL₂,. Ces deux masques MRL₁ et MRL₂ correspondent à un dessin différent, typiquement au niveau de l'évasement vers la périphérie, des lignes de la matrice.

Sur la figure 12b, on a un deuxième réticule qui comporte deux masques latéraux flous, un gauche M_{LFUZZY}, et un droit M_{LFUZZY}, et le masque de zone active selon l'invention, M_{ZAFUZZY}. La différence avec la réalisation précédente, est que les masques latéraux flous gauche et droit sont respectivement insolés sur les bords de la zone active, en rayé sur la figure 13, respectivement sur le bord latéral droit, gauche de la zone floue (en grisé) amené par le masque de zone active.

L'image du deuxième réticule est représentée sur la figure 12.

L'invention qui vient d'être expliquée et illustrée au moyen d'exemples pratiques de réalisation s'applique d'une manière générale à la fabrication de matrice active, pour dispositif de visualisation. Elle permet d'améliorer leurs qualités électro-optiques. En particulier la qualité visuelle cosmétique des écrans haute densité est sensiblement améliorée.

L'invention peut s'appliquer à tout autre procédé de fabrication par photogravure de motifs devant se répéter sur une surface plus grande que la zone insolée en une seule fois et dont les propriétés doivent être identiques, par exemple, pour des matrices de capteurs, de détecteurs, par exemple des détecteurs de rayons X.

## Revendications

1. Procédé de fabrication d'une matrice active comprenant une zone active comportant un ensemble de cellules disposées selon un réseau croisé de lignes et de colonnes, ledit procédé comprenant au moins une étape de dépôt d'une couche d'un matériau et d'insolation de cette couche, pour insoler par report d'un masque de zone active, un motif identique (m) de cellule en chaque point d'intersection (pᵢ) d'une ligne et d'une colonne du réseau, avec une zone de recouvrement (ZR)de largeur non nulle entre deux champs d'insolation successifs (INS₁, INS₂), chaque insolation n'amenant pas le motif (m) de cellule en tous les points dans ladite zone de recouvrement, dans lequel un même masque est reporté plusieurs fois suivant les deux directions du réseau de lignes et de colonnes pour couvrir l'ensemble de la zone active, ledit masque comprenant une partie périphérique (M-zp) dans laquelle des motifs ne sont pas réalisés en certains points (pₐ, p_{b}), autour d'une zone centrale (M-zc) dans laquelle tous les motifs sont réalisés, la largeur de la zone de recouvrement (ZR) entre deux champs d'insolation successifs (INS₁, INS₂) dans une direction de report correspondant à une largeur de ladite zone périphérique du masque, et **caractérisé en ce que** la répartition des motifs dans ladite partie périphérique est définie en fonction d'un mode d'adressage des lignes et colonnes, avec inversion de polarité, de sorte que chaque insolation amène dans une zone de recouvrement autant de motifs de cellule dans chaque polarité.

2. Procédé de fabrication selon la revendication 1, **caractérisé en ce qu'**un champ d'insolation (CH1) correspondant à une insolation du masque de zone active (MZA_{FUZZY}) comprend une zone centrale (zc) dans laquelle la densité des motifs amenée par l'insolation est égale à un, et des zones de recouvrement (zr, zl, zt, zb) périphériques de la zone centrale dans lesquelles la densité de motifs amenée par une insolation est inférieure à 1, lesdites zones de recouvrement correspondant à une partie latérale gauche (zr), respectivement droite (zl), supérieure (zt) et inférieure (zb), lesdites zones de recouvrement ayant en commun deux à deux un coin du champ (c1, c2, c3, c4).

3. Procédé de fabrication selon la revendication 2, **caractérisé en ce que** la densité de motifs amenée par une insolation dans les zones de recouvrement est sensiblement égale à ½, excepté dans les coins où elle est sensiblement égale à ¼.

4. Procédé de fabrication selon l'une quelconque des revendications précédentes, **caractérisé en ce que** dans une zone de recouvrement de champs, les motifs amenés par une insolation sont répartis selon un dégradé sur la largeur de la zone de recouvrement, les motifs étant de moins en moins nombreux en limite de champ.

5. Procédé de fabrication selon la revendication 4, **caractérisé en ce que** le dégradé suit une loi linéaire sur toute la largeur de la zone de recouvrement.

6. Procédé de fabrication selon l'une des revendications 1 à 5, d'une matrice organisée selon une structure de points images Pᵢ, correspondant à une structure de filtres colorés, chaque point image comprenant un groupe de n cellules disposées sur des lignes et/ou des colonnes successives, chacune des n cellules étant associée à une couleur de filtre, **caractérisé en ce que** la répartition des motifs amenés par une insolation dans une zone de recouvrement d'un champ (CH1) est telle que dans chaque point image de cette zone, il ne peut pas manquer que 0 ou n motifs.

7. Procédé de fabrication selon l'une quelconque des revendications 1 à 5, chaque cellule de la matrice étant associée à une couleur de filtre, selon une structure de filtres colorés telle que chaque ligne de la matrice comprend autant de cellules par couleur de filtre, **caractérisé en ce que** la répartition des motifs amenés par une étape d'insolation dans une zone de recouvrement est telle que l'on a sur chaque ligne de cette zone autant de motifs amenés dans chaque couleur de filtre.

8. Procédé de fabrication selon la revendication 1, **caractérisé en ce que** la répartition des motifs amenés par une insolation dans une zone de recouvrement est telle que les motifs de cellules manquent au moins par deux cellules de polarité opposée les plus proches voisines.

9. Procédé de fabrication d'une matrice selon la revendication 8, chaque cellule de la matrice étant associée à une couleur de filtre, **caractérisé en ce que** la répartition des motifs amenés par une insolation dans une zone de recouvrement est telle que les motifs de cellules manquent au moins par deux cellules de polarité opposée et de même couleur les plus proches voisines.

10. Procédé de fabrication selon l'une quelconque des revendications 1 à 9, **caractérisé en ce qu'**il est appliqué à chacune des étapes de dépôt d'une couche de matériau et de réalisation d'un motif de cellule sur cette couche par photo-insolation d'un masque de zone active correspondant.

11. Procédé de fabrication selon l'une quelconque des revendications 1 à 9, pour une matrice active à transistors, chaque cellule de la matrice comprenant un élément pixel avec une électrode pixel et un transistor connecté au réseau de lignes et de colonnes, chaque transistor comprenant une grille, une première et une deuxième électrode, un canal semi-conducteur entre la grille et les électrodes, la première électrode étant connectée à une colonne de la matrice, la deuxième électrode étant connecté à une électrode pixel et la grille étant connectée à une ligne de la matrice, **caractérisé en ce que** le procédé de recouvrement est appliqué au moins à chacune des couches (b, d, e, c) sur lesquelles sont formées les colonnes, les canaux semi-conducteurs et les électrodes pixels.

12. Procédé selon la revendication 10 ou 11, **caractérisé en ce que** pour les couches de la matrice auxquelles le procédé de recouvrement est appliqué, les zones de recouvrement sont aux même emplacements sur la zone active, et avec une même répartition des motifs entre les différentes étapes d'insolation de ces zones d'une couche à l'autre.

13. Masque pour insoler un dessin formé de motifs identiques (m) de cellules d'une matrice active disposées selon un réseau croisé de lignes et de colonnes, chaque motif étant dessiné au point d'intersection (pᵢ) d'une ligne et d'une colonne, ledit masque comprenant une partie périphérique (M-zp) autour d'une zone centrale (M-zc), le dessin étant incomplet dans la zone périphérique, des motifs n'étant pas réalisés en certains points (pₐ, p_{b}) de cette zone, et **caractérisé en ce que** la répartition des motifs dans ladite zone périphérique est définie en fonction d'un mode d'adressage des lignes et colonnes, avec inversion de polarité, de sorte que chaque insolation amène dans ladite zone de recouvrement autant de motifs de cellule dans chaque polarité.

14. Masque selon la revendication 13, **caractérisé en ce que** la zone périphérique (M-zp) comprend une partie latérale gauche (M-zl), une partie latérale droite (M-zl) et une partie supérieure (M-zt) et une partie inférieure (M-zb), lesdites parties ayant en commun deux à deux un coin parmi les quatre coins du masque (M-c1, M-c2, M-c3, M-c4), **caractérisé en ce que** la répartition des points sans motifs dans la zone périphérique est telle que les parties latérales gauche et droite, respectivement supérieure et inférieure, sont complémentaires, le dessin de l'une étant le négatif de l'autre en dehors des coins, et **en ce que** les quatre coins sont complémentaires.

15. Masque selon la revendication 14, **caractérisé en ce que** la répartition des points sans motifs entre les parties complémentaires entre elles, est aléatoire ou pseudo-aléatoire.

16. Masque selon l'une quelconque des revendications 13 à 15, **caractérisé en ce que** la densité de motifs dans chaque partie de la zone périphérique est sensiblement égale à ½, excepté dans les coins du masque où elle est sensiblement égale à ¼.

17. Masque selon l'une quelconque des revendications 13 à 16, **caractérisé en ce que** la répartition des points sans motifs dans la zone périphérique (M-zp) suit un dégradé horizontal dans les parties latérales (M-zr, M-zl), et vertical dans les parties supérieure et inférieure (M-zt, M-zb), les points sans motifs étant de moins en moins nombreux aux abords de la zone centrale (M-zc) du masque.

18. Masque d'insolation selon la revendication 17, **caractérisé en ce que** le dégradé est linéaire.

19. Masque selon l'une quelconque des revendications 13 à 18, **caractérisé en ce que**, en regroupant les points par série de n points successifs selon les lignes, correspondant à une matrice à structure périodique de n filtres colorés selon les lignes, et en attribuant un rang 1, ...n à chaque point dans chaque série, la répartition des points sans motifs dans la zone périphérique (M-zp) du masque est telle qu' il y a autant de points sans motifs dans chaque ligne.

20. Masque selon la revendication 19, **caractérisé en ce que** dans les séries de points d'une ligne, il n'y a pas que des séries qui ne comprennent que des points sans motifs ou que aucun point sans motif.

21. Masque selon l'une quelconque des revendications 13 à 20, **caractérisé en ce que** dans la zone périphérique, les points sans motifs manquent au moins par deux points successifs (pₑ, p_{f}) le long des colonnes ou des lignes.

22. Masque selon l'une quelconque des revendications 13 à 20, **caractérisé en ce que** les points sans motifs manquent au moins par paires selon les lignes et/ou les colonnes, chaque paire de points correspondant à deux cellules les plus proches voisines adressées avec des polarités opposées.

23. Masque selon la revendication 22, **caractérisé en ce que** la répartition des points sans motifs points dans la zone périphérique (M-zp) du masque est telle que les paires de points sans motifs correspondent dans une matrice active à structure de filtres colorés, à des cellules les plus proches voisines adressées avec des polarités opposées et de même couleur.

## Patentansprüche

1. Verfahren zur Herstellung einer aktiven Matrix, die eine aktive Zone mit einem Satz von Zellen umfasst, die zu einem Gitter von sich schneidenden Reihen und Spalten angeordnet sind, wobei das Verfahren wenigstens einen Schritt des Absetzens einer Materialschicht und des Belichtens dieser Schicht beinhaltet, um durch Übertragen einer aktiven Zonemnaske ein identisches Zellerunuster (m) an jedem Schnittpunkt (pᵢ) einer Reihe und einer Spalte des Gitters zu belichten, mit einer Überlappungszone (ZR) einer Breite von gleich null zwischen zwei aufeinander folgenden Belichtungsfeldern (INS₁, Ins₂), wobei jede Belichtung das Zellenmuster (m) nicht zu allen Punkten in der Überlappungszone führt, in der dieselbe Maske mehrere Male in beiden Richtungen des Gitters von Reihen und Spalten übertragen wird, um die gesamte aktive Zone zu bedecken, wobei die Maske einen peripheren Teil (M-zp) aufweist, in dem Muster an bestimmten Punkten (pa, pb) eine mittlere Zone (M-zc), in der alle Muster realisiert werden, nicht realisiert werden, wobei die Breite der Überlappungszone (ZR) zwischen zwei aufeinander folgenden Belichtungsfeldern (INS₁, INS₂) in einer Übertragungsrichtung einer Breite der peripheren Zone der Maske entspricht, und **dadurch gekennzeichnet, dass** die Verteilung von Mustern in dem peripheren Teil in Abhängigkeit von einem Modus des Adressierens von Reihen und Spalten mit Polaritätsumkehr definiert wird, so dass jede Belichtung in einer Überlappungszone gleich viele Zellenmuster in jeder Polarität zuführt.

2. Herstellungsverfahren nach Anspruch 1, **dadurch gekennzeichnet, dass** ein einer Belichtung der tiven Zonenmaske (MZA_{FUZZY}) entsprechendes Belichtungsfeld (CH1) eine mittlere Zone (zc), in der die Dichte der durch die Belichtung zugeführten Muster gleich eins ist, und periphere Überlappungszonen (zr, zl, zt, zb) der mittleren Zone aufweist, in denen die Dichte von durch eine Belichtung zugeführten Mustern kleiner als 1 ist, wobei die Überlappungszonen einem linksseitigen (zr) bzw. einem rechtsseitigen (zl) Teil, einem oberen (zt) und einem unteren (zb) Teil entspechen, wobei die Überlappungszonen paarweise eine Ecke des Feldes (c1, c2, c3, c4) gemeinsam haben.

3. Herstellungsverfahren nach Anspruch 2, **dadurch gekennzeichnet, dass** die durch Belichtung in den Überlappungszonen zugeführte Dichte von Mustern im Wesentlichen gleich ½ ist, ausgenommen an den Ecken, wo sie im Wesentlichen gleich ¼ ist.

4. Herstellungsverfahren nach einem der vorherigen Ansprüche, **dadurch gekennzeichnet, dass** in einer Feldüberlappungszone die durch Belichtung zugeführten Muster gemäß einer Abstufung an der Breite der Überlappungszone verteilt werden, wobei die Zahl der Muster an der Umgrenzung des Feldes immer geringer wird.

5. Herstellungsverfahren nach Anspruch 4, **dadurch gekennzeichnet, dass** die Abstufung einem linearen Gesetz über die gesamte Breite der Überlappungszone folgt.

6. Herstellungsverfahren nach einem der Ansprüche 1 bis 5 für eine gemäß einer Bildpunktstruktur Pᵢ organisierte Matrix, entsprechend einer Farbfilterstruktur, wobei jeder Bildpunkt eine Gruppe von n Zellen umfasst, die in aufeinander folgenden Reihen und/Spalten angeordnet sind, wobei jede der n Zellen mit einer Filterfarbe assoziiert ist, **dadurch gekennzeichnet, dass** die Verteilung der durch Belichtung zugeführten Muster in einer Überlappungszone eines Feldes (CH1) derart ist, dass in jedem Bildpunkt dieser Zone nicht nur 0 oder n Muster fehlen können.

7. Herstellungsverfahren nach einem der Ansprüche 1 bis 5, wobei jede Zelle der Matrix mit einer Filterfarbe gemäß einer Farbfilterstruktur assoziiert ist, so dass jede Reihe der Matrix gleich viele Zellen pro Filterfarbe umfasst, **dadurch gekennzeichnet, dass** die Verteilung der durch einen Belichtungsschritt in einer Überlappungszone zugeführten Muster derart ist, dass es in jeder Reihe dieser Zone gleich viele in jeder Filterfarbe zugeführte Muster gibt.

8. Herstellungsverfahren nach Anspruch 1, **dadurch gekennzeichnet, dass** die Verteilung der durch Belichtung in einer Überlappungszone zugeführten Muster derart ist, dass die Zellenmuster wenigstens jeweils durch zwei einander am nächsten liegende Zellen von entgegengesetzter Polarität fehlen.

9. Verfahren zur Herstellung einer Matrix nach Anspruch 8, wobei jede Zelle der Matrix mit einer Filterfarbe assoziiert ist, **dadurch gekennzeichnet, dass** die Verteilung der durch Belichtung in einer Überlappungszone zugeführten Muster derart ist, dass die Zellenmuster wenigstens jeweils durch zwei am nächsten liegende Zellen von entgegengesetzter Polarität und von derselben Farbe fehlen.

10. Herstellungsverfahren nach einem der Ansprüche 1 bis 9, **dadurch gekennzeichnet, dass** es auf jeden der Schritte des Absetzens einer Materialschicht und des Realisierens eines Zellenmuster auf dieser Schicht durch Fotobelichtung einer entsprechenden aktiven Zonenmaske angewandt wird.

11. Herstellungsverfahren nach einem der Ansprüche 1 bis 9 für eine aktive Transistormatrix, wobei jede Zelle der Matrix ein Pixelelement mit einer Pixelelektrode und einen mit dem Gitter von Reihen und Spalten verbundenen Transistor umfasst, wobei jeder Transistor ein Gatter, eine erste und eine zweite Elektrode, einen Halbleiterkanal zwischen dem Gatter und den Elektroden umfasst, wobei die erste Elektrode mit einer Spalte der Matrix, die zweite Elektrode mit einer Pixelelektrode und das Gatter mit einer Reihe der Matrix verbunden sind, **dadurch gekennzeichnet, dass** das Überlappungsverfahren wenigstens auf jede der Schichten (b, d, e, c) angewandt wird, auf denen die Spalten, die Halbleiterkanäle und die Pixelelektrode ausgebildet sind.

12. Verwahren nach Anspruch 10 oder 11, **dadurch gekennzeichnet, dass** sich für die Schichten der Matrix, auf die das Überlappungsverfähren angewandt wird, die Überlappungszonen an denselben Stellen auf der aktiven Zone und mit derselben Musterverteilung zwischen den verschiedenen Belichtungsschritten dieser Zonen von einer Schicht zur nächsten befinden.

13. Maske zum Belichten einer Zeichnung, die von identischen Mustern (m) von Zellen einer aktiven Matrix gebildet ist, die zu einem Gitter von sich schneidenden Reihen und Spalten geordnet sind, wobei jedes Muster am Schnittpunkt (pi) einer Reihe und einer Spalte gezeichnet ist, wobei die Maske einen peripheren Teil (M-zp) um eine mittlere Zone (M-zc) umfasst, wobei die Zeichnung in der peripheren Zone unvollständig ist, wobei Muster an bestimmten Punkten (pa, pb) dieser Zone nicht realisiert werden, und **dadurch gekennzeichnet, dass** die Verteilung von Mustern in der peripheren Zone in Abhängigkeit von einem Modus des Adressierens der Reihen und Spalten definiert wird, mit Polaritätsumkehr, so dass jede Belichtung in der Überlappungszone gleich viele Zellenmuster in jeder Polarität zuführt.

14. Maske nach Anspruch 13, **dadurch gekennzeichnet, dass** die periphere Zone (M-zp) einen linksseitigen Teil (M-zl), einen rechtsseitigen Teil (M-zr) und einen oberen Teil (M-zt) sowie einen unteren Teil (M-zb) umfasst, wobei die Teile paarweise eine Ecke aus den vier Ecken der Maske (M-c1, M-c2, M-c3, M-c4) gemeinsam haben, **dadurch gekennzeichnet, dass** die Verteilung von musterlosen Punkten in der peripheren Zone derart ist, dass der links- und rechtsseitige bzw. der obere und untere Teil komplementär sind, wobei die Zeichnung von einem das Negativ des anderen außerhalb der Ecken ist, und dadurch, dass die vier Ecken komplementär sind.

15. Maske nach Anspruch 14, **dadurch gekennzeichnet, dass** die Verteilung von usterlosen Punkten zwischen den zueinander komplementären Teilen zufällig oder pseudozufällig ist.

16. Maske nach einem der Ansprüche 13 bis 15, **dadurch gekennzeichnet, dass** die Dichte von Mustern in jedem Teil der peripheren Zone etwa gleich 1/2 aufgenommen an den Ecken der Maske, wo sie im Wesentlichen gleich ¼ ist.

17. Maske nach einem der Anspruche 13 bis 16, **dadurch gekennzeichnet, dass** die Verteilung von musterlosen Punkten in der peripheren Zone (M-zp) einer horizontalen Abstufung in den seitlichen Teilen (M-zr, M-zl) und einer vertikalen Abstufung im oberen und unteren Teil (M-zt, M-zb) folgt, wobei die Zahl der musterlosen Punkte an den Rändern der mittleren Zone (M-zc) der Maske immer geringer wird.

18. Belichtungsmaske nach Anspruch 17, **dadurch gekennzeichnet, dass** die Abstufung linear ist.

19. Maske nach einem der Anspruche 13 bis 18, **dadurch gekennzeichnet**, durch Gruppieren der Punkte zu einer Serie von n aufeinander folgenden Punkten entlang den Reihen, entsprechend einer Matrix mit einer periodischen Struktur von n Farbfiltern entlang den Reihen, und durch Zuordnen eines Rangs 1, ...n zu jedem Punkt in jeder Serie, die Verteilung von musterlosen Punkten in der peripheren Zone (M-zp) der Maske derart ist, dass es gleich viele musterlose Punkte in jeder Reihe gibt.

20. Maske nach Anspruch 19, **dadurch gekennzeichnet, dass** es in den Punktserien einer Reihe nicht nur Serien gibt, die ausschließlich musterlose Punkte oder keine musterlosen Punkte enthalten.

21. Maske nach einem der Ansprüche 13 bis 20, **dadurch gekennzeichnet, dass** die musterlosen Punkte in der peripheren Zone wenigstens jeweils durch zwei aufeinander folgende Punkte (pe, pf) entlang den Spalten oder Reihen fehlen.

22. Maske nach einem der Ansprüche 13 bis 20, **dadurch gekennzeichnet, dass** die musterlosen Punkte wenigstens paarweise entlang den Reihen und/oder Spalten fehlen, wobei jedes Punktepaar zwei einander am nächsten liegenden Zellen entspricht, die mit entgegengesetzten Polaritäten adressiert werden.

23. Maske nach Anspruch 22, **dadurch gekennzeichnet, dass** die Verteilung von musterlosen Punkten in der peripheren Zone (M-zp) der Maske derart ist, dass die Paare von musterlosen Punkten in einer aktiven Matrix mit einer Farbfilterstruktur den einander am nächsten liegenden Zellen entsprechen, die mit entgegengesetzten Polaritäten und derselben Farbe adressiert werden.

## Claims

1. A method for manufacturing an active matrix comprising an active zone including a set of cells disposed on an intersecting network of rows and columns, said method comprising at least one step of depositing a layer of material and of exposing said layer, so as to expose, by transferring an active zone mask, an identical cell pattern (m) at each intersection point (pᵢ) of a row and a column of the network, with an overlap zone (ZR) of non-zero width between two successive exposure fields (INS1, INS2), each exposure not providing the cell pattern (m) at all of the points in said overlap zone, wherein the same mask is transferred several times along both directions of the network of rows and columns so as to cover all of the active zone, said mask comprising a peripheral part (M-zp), in which patterns are not realised at certain points (pa, pb), around a central zone (M-zc), in which all of the patterns are realised, the width of the overlap zone (ZR) between two successive exposure fields (INS1, INS2) in a transfer direction corresponding to a width of said peripheral zone of the mask, and **characterised in that** the distribution of patterns inside said peripheral part is defined as a function of a mode for addressing rows and columns, with polarity reversal, so that each exposure provides the same amount of cell patterns in each polarity in an overlap zone.

2. The manufacturing method according to claim 1, **characterised in that** an exposure field (CH1) corresponding to an exposure of the active zone mask (MZA_{FUZZY}) comprises a central zone (zc) in which the density of the patterns provided by the exposure is equal to one, and peripheral overlap zones (zr, zl, zt, zb) of the central zone in which the density of patterns provided by an exposure is less than 1, said overlap zones corresponding to a left-hand side part (zr), a right-hand side part (zl), respectively, an upper part (zt) and a lower part (zb), said overlap zones pairwise sharing a corner of the field (c1, c2, c3, c4).

3. The manufacturing method according to claim 2, **characterised in that** the density of patterns provided by an exposure in the overlap zones is substantially equal to ½, except in the corners where it is substantially equal to ¼.

4. The manufacturing method according to any one of the preceding claims, **characterised in that** in a fields overlap zone, the patterns provided by an exposure are distributed according to a gradation on the width of the overlap zone, the number of patterns being increasingly less at the boundary of the field.

5. The manufacturing method according to claim 4, **characterised in that** the gradation follows a linear rule over the entire width of the overlap zone.

6. The manufacturing method according to any one of claims 1 to 5, for a matrix organised according to an image point Pᵢ structure, corresponding to a structure of coloured filters, each image point comprising a group of n cells disposed on successive rows and/or columns, each of the n cells being associated with a filter colour, **characterised in that** the distribution of the patterns provided by an exposure in an overlap zone of a field (CH1) is such that in each image point of this zone not only 0 or n patterns can be lacking.

7. The manufacturing method according to any one of claims 1 to 5, each cell of the matrix being associated with a filter colour, according to a structure of coloured filters such that each row of the matrix comprises the same amount of cells per filter colour, **characterised in that** the distribution of the patterns provided by an exposure step in an overlap zone is such that the same amount of patterns is provided in each filter colour on each row of this zone.

8. The manufacturing method according to claim 1, **characterised in that** the distribution of the patterns provided by an exposure in an overlap zone is such that the cell patterns lack by at least respectively two immediately adjacent cells with opposite polarity.

9. The method for manufacturing a matrix according to claim 8, each cell of the matrix being associated with a filter colour, **characterised in that** the distribution of the patterns provided by an exposure in an overlap zone is such that the cell patterns lack by at least two immediately adjacent cells with opposite polarity and the same colour.

10. The manufacturing method according to any one of claims 1 to 9, **characterised in that** it is applied to each of the steps of depositing a layer of material and of realising a cell pattern on this layer by photo-exposure of a corresponding active zone mask.

11. The manufacturing method according to any one of claims 1 to 9, for an active transistor matrix, each cell of the matrix comprising a pixel element with a pixel electrode and a transistor connected to the network of rows and columns, each transistor comprising a gate, a first and a second electrode, a semi-conducting channel between the gate and the electrodes, the first electrode being connected to a column of the matrix, the second electrode being connected to a pixel electrode and the gate being connected to a row of the matrix, **characterised in that** the overlap method is at least applied to each of the layers (b, d, e, c) on which the columns, the semi-conducting channels and the pixel electrodes are formed.

12. The method according to claim 10 or 11, **characterised in that**, for the layers of the matrix to which the overlap method is applied, the overlap zones are at the same locations on the active zone, and with the same distribution of patterns between the various exposure steps of these zones from one layer to the next.

13. A mask for exposing a drawing formed of identical patterns (m) of cells of an active matrix disposed on an intersecting network of rows and columns, each pattern being drawn at the intersection point (pi) of a row and a column, said mask comprising a peripheral part (M-zp) around a central zone (M-zc), said drawing being incomplete in the peripheral zone, patterns not being realised at certain points (pa, pb) of this zone, and **characterised in that** the distribution of patterns in said peripheral zone is defined as a function of a mode for addressing the rows and columns, with polarity reversal, so that each exposure provides the same amount of cell patterns in each polarity in said overlap zone.

14. The mask according to claim 13, **characterised in that** the peripheral zone (M-zp) comprises a left-hand side part (M-zl), a right-hand side part (M-zl) and an upper part (M-zt) and a lower part (M-zb), said parts pairwise sharing a corner from amongst the four corners of the mask (M-c1, M-c2, M-c3, M-c4), **characterised in that** the distribution of the pattern-free points in the peripheral zone is such that the left-hand and right-hand parts and upper and lower parts, respectively, are complementary, the drawing of one being the negative of the other outside of the corners, and **in that** the four corners are complementary.

15. The mask according to claim 14, **characterised in that** the distribution of the pattern-free points between the parts that are complementary with each other is random or pseudo-random.

16. The mask according to any one of claims 13 to 15, **characterised in that** the density of patterns in each part of the peripheral zone is substantially equal to ½, except in the corners of the mask where it is substantially equal to ¼.

17. The mask according to any one of claims 13 to 16, **characterised in that** the distribution of the pattern-free points in the peripheral zone (M-zp) follows a horizontal gradation in the side parts (M-zr, M-zl) and a vertical gradation in the upper and lower parts (M-zt, M-zb), the pattern-free points being increasingly less at the boundaries of the field of the central zone (M-zc) of the mask.

18. The exposure mask according to claim 17, **characterised in that** the gradation is linear.

19. The mask according to any one of claims 13 to 18, **characterised in that**, by grouping the points in series of n successive points along the rows, corresponding to a matrix with a periodic structure of n filters coloured along the rows, and assigning a rank 1, ...n to each point in each series, the distribution of the pattern-free points in the peripheral zone (M-zp) of the mask is such that there is the same amount of pattern-free points in each row.

20. The mask according to claim 19, **characterised in that** in the series of points of a row, there are exclusively series that exclusively comprise pattern-free points or no pattern-free points at all.

21. The mask according to any one of claims 13 to 20, **characterised in that** in the peripheral zone, the pattern-free points lack by at least respectively two successive points (pe, pf) along the length of the columns or rows.

22. The mask according to any one of claims 13 to 20, **characterised in that** the pattern-free points lack at least respectively pairs along the rows and/or the columns, each pair of points corresponding to two cells that are immediately adjacent addressed with opposite polarities.

23. The mask according to claim 22, **characterised in that** the distribution of the pattern-free points in the peripheral zone (M-zp) of the mask is such that the pairs of pattern-free points correspond, in an active matrix with a structure of coloured filters, to the cells that are immediately adjacent addressed with opposite polarities and of the same colour.
